# EUROPEAN PATENT APPLICATION

(11) **EP 4 580 060 A1**
(43) Date of publication of application: **02.07.2025**
(21) Application number: 23472010.0
(22) Date of filing: 28.12.2023
(51) Int. Cl.: H03K 17/95, H03K 17/97

(54) **MAGNETIC SWITCH**

(71) Applicant: Melexis Bulgaria EOOD, 1138 Sofia (BG)
(72) Inventor: Tombez, Lionel, 2022 Bevaix (CH); Georgiev Gaydov, Stoyan, 1138 Sofia (BG)
(74) Representative: Winger

(57) **Abstract**

A magnetic switch includes a magnetic field sensing system configured for performing a measurement of the component of the magnetic field in at least two different directions and providing a signal representative of the measurement. Comparing means allow to sequentially compare the signal with a respective threshold value. The comparing means are adapted to provide a first threshold value being a predetermined value for a first comparison. wherein the switch is configured to repeat the comparison using the signal representative of the measurement in a different direction and a respective threshold value. The comparing means are further adapted to provide a further threshold value for the further comparison. The threshold value is chosen in accordance with at least one measurement of the component of the magnetic field used in a previous comparison. The magnetic switch also comprises a connection to output the result of at least one comparison.

## Description

### Field of the invention

The invention relates to the field of magnetic field sensing. More specifically it relates to a magnetic switch and uses thereof in proximity sensing.

### Background of the invention

Several applications require the use of magnetic field sensors, which use magnetic field sensing elements. These applications include current sensors that senses a magnetic field generated by a current through a conductor, position sensors for detecting position of a magnetic source, for example a rotation detector that senses passing of a magnetically sensitive materials such as gear teeth and the like.

In particular, magnetic switches are a type of position sensors that can be used to detect the presence or proximity of a magnetic object. Magnetic switches provide an output that is, in general, binary, indicating either the presence or the absence of the magnetic object within a range. A threshold is defined, and the detected field is compared to the threshold, so that the switch provides a response or output depending on the result of the comparison.

Usually, magnetic switches detect the magnetic field in one direction using sensing elements. This means that the rest of components of the field may not be detected. Careful alignment is required, otherwise if the field is misaligned, switching may not be triggered even if the field is large enough to do so, since the switching only detects a reduced signal due to the misalignment. This introduces uncertainty in the switching. It may result in malfunctions.

Existing solutions include magnetic sensing in multiple directions (e.g. two-dimensional (2D) or three-dimensional (3D) switches), but these existing solutions are either too simple and improve the sensitivity of the switch only slightly, or they require complex vectorial calculations and/or extensive memory usage to obtain an accurate threshold comparison with the actual magnetic field.

It would be desirable to provide accurate magnetic switching with a simple implementation.

### Summary of the invention

It is an object of embodiments of the present invention to provide a magnetic switch for detecting magnetic field in two or three directions with a simple processing, good resolution and accurate approximation.

In a first aspect, the present invention provides a magnetic switch comprising a magnetic field sensing system configured for performing a measurement of a first component of the magnetic field in a first direction, and a measurement of at least a second component of the magnetic field in a second direction different from the first direction, and providing a measurement signal representative of each measurement.

The switch further comprises comparing means adapted for comparing the measurement signal with a respective threshold value.

The comparing means are adapted to provide a first threshold value for a first comparison with the first component in the first direction, the first threshold value being a predetermined value. The switch is also configured to perform a further comparison using the measurement signal of a field component in a different direction and using a subsequent threshold value. The comparing means is also adapted to provide the subsequent threshold value for the further comparison.

At least one of said subsequent threshold value is chosen in accordance with a measurement signal of at least one component of the magnetic field used in a previous comparison. The magnetic switch comprises a connection to provide a signal representative of the result of at least one comparison as output signal.

It is an advantage of embodiments of the present invention that an accurate switching can be obtained with no need to compute squares or large look-up tables. It is a further advantage that reduced processing time can be provided.

In some embodiments of the present invention, the switch comprises signal processing means for providing a measurement signal of the measurement of a first component and/or of at least a second component. The measurement signal may be representative of the absolute value of the respective component of the magnetic field in at least one direction.

It is an advantage of embodiments of the present invention that the computation of the absolute value can be done easily, for example with an analog circuit such as a multiplier, rectifier, amplifier, etc., or even digitally.

In some embodiments of the present invention, the magnetic field sensing system comprises a sensing element being a Hall element configured so that the direction of maximum sensitivity is the direction of the component being measured.

It is an advantage of embodiments of the present invention that the switch can be provided with Hall elements in an integrated device. For example two components may be measured with respective Hall elements.

In some embodiments of the present invention, the switch further comprises one or more integrated magnetic concentrators for redirecting the magnetic field in at least one predetermined direction being the direction of maximum sensitivity of the Hall element.

In some embodiments of the present invention, the comparing means comprises a look-up table with a list of threshold values corresponding to different measurement signals of at least one component of the magnetic field.

It is an advantage of embodiments of the present invention that a spherical range of the switch can be obtained with a single look-up table.

For example, the look-up table comprises a list of threshold values corresponding to different measurement signals corresponding to absolute values of a component of the magnetic field.

It is an advantage of embodiments of the present invention that the look-up table can be further reduced.

In some embodiments of the present invention, the switch is configured to repeat the comparison for a different component if the measurement signal of a component is lower than the corresponding threshold to which the measurement signal is compared to. The switch may be configured to repeat the comparison until the measurement signals of each component has been compared, or until the measurement signal of at least one component is higher than the respective threshold.

It is an advantage of embodiments of the present invention that the operations can be simplified. For example, the size of the lookup table or tables can be reduced, since a full mapping of the detection area is not needed. It is an additional advantage that the processing time is reduced.

In some embodiments of the present invention, the comparing means are adapted to provide a subsequent threshold value for each subsequent comparison, wherein at least one of said subsequent threshold value is chosen in accordance with the measurement signal corresponding to the absolute value of at least one component of the magnetic field used in a previous comparison, e.g. in the previous comparison.

It is an advantage of embodiments of the present invention that the operation can be simplified. For example, the size of the look-up table can be further reduced by including only absolute values since the sensitivity of the device may be symmetrical. It is an advantage of embodiments of the present invention that the look-up table only requires one set of distances. It is a further advantage that the computational speed is increased since it is required to provide a threshold from a look-up table only once.

In some embodiments of the present invention, the magnetic field sensing system is configured for providing a measurement signal of each component of the magnetic field in three different directions.

It is an advantage of embodiments of the present invention that a 3D switch can be provided.

In some embodiments of the present invention, the comparing means is configured to provide a further threshold value being a predetermined value.

It is an advantage of embodiments of the present invention that the size of the table only requires one component and the operations are further reduced.

In some embodiments of the present invention, alternatively, the comparing means is configured to provide a second and third thresholds, based on the measurement signal of the same component of the magnetic field.

It is an advantage of embodiments of the present invention that the number of tables is reduced, and a spherical detection zone can be provided.

In some embodiments of the present invention, the comparing means is configured to provide a second and/or third thresholds based on the measurement signals of different components of the magnetic field.

It is an advantage of embodiments of the present invention that the shape of the detection volume can be tailored.

In some embodiments of the present invention the switch is configured to provide an output signal being either the first output corresponding to a measurement of a component being higher that the respective threshold value, or the result of the last comparison. The switch is adapted to stop the comparison sequence when the signal representative of the result of at least one comparison is provided.

In a further aspect, the present invention provides a proximity sensing system comprising a magnet and a magnetic switch of the previous aspect, for detecting the proximity of the magnet within a predetermined distance range. The system is adapted to use the signal representative of the measurement to indicate proximity if a measurement signal surpasses its respective threshold.

It is an advantage of embodiments of the present invention that a proximity sensing system can be provided with a simple and reliable magnetic sensor as a magnetic switch. In some embodiments, the magnetic field of the magnet may be between 0.5 mT to 100 mT.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG. 1 shows graphically the switching behavior as a response of the measurement of two components of the field in two directions of the plane, where a threshold is defined for each component, being threshold 'a' for the horizontal component and threshold 'b' for the vertical component.
FIG. 2 is a graphical representation of a sensing area in terms of the magnetic field. The switching threshold is given by a given shape, in the case of the figure a circumference. Thus, a maximum threshold is defined for a component of the field in one direction, and if the component does not surpass the field, the threshold for the second direction is calculated on the basis of the equation of the shape (e.g. circumference) and of the result of the field in the preceding direction.
FIG. 3 is a graphical representation of a sensing volume, for a 3D switch. A further switching condition is given by the third dimension. In some embodiments, the sensing volume may be a sphere, the present invention not being limited thereto.
FIG. 4 is a graphical representation of the calculation of a threshold in the vertical direction based on the measurement of the horizontal component of the magnetic field, when said component, for example is lower than the maximum horizontal threshold X, so the component in the vertical direction may be either inside or outside the threshold area.
FIG. 5 and FIG. 6 show planar views of two exemplary sensor configurations including sensing elements for sensing different components of the field.
FIG. 7 shows a perspective and side cross-section of a sensor including magnetic concentrators and sensing elements.
FIG. 8 shows a planar view of an exemplary sensor configuration including sensing elements for sensing different components of the field.
FIG. 9 shows schematically a magnetic switch in accordance with embodiments of the present invention.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings but the invention is not limited thereto but only by the claims. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. Thus, the scope of the expression "a device comprising means A and B" should not be interpreted as being limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Where in embodiments of the present invention reference is made to "magnetic switch", reference is made to a magnetic field detector which is configured to provide an output signal representative either a first state or a second state being different from the first under a certain condition or threshold. In binary, the output of a switch is either a 0 signal or a 1 signal. For an electronic switch, the condition that causes switching from one state to another (or 'switching condition') is the presence of, for example, an electric potential larger than a predetermined threshold. In the case of a magnetic switch, the switching condition is the presence or absence of a magnetic field over a predetermined threshold value, or switching threshold, or simply 'threshold' in the following.

The present invention relates to a magnetic switch, including a magnetic field sensing system for detecting or sensing magnetic fields.

The magnetic field sensing system may detect at least two magnetic field components in different directions. Based on these components, a comparison with a threshold is performed. The output of the comparison determines whether there is a switching or not. This is translated to the determination of whether the source of the field is closer than a distance threshold or not. In other words, the value of the magnetic field is used as an approximation for the distance of the source to the detector.

A simple and accurate implementation of a magnetic switch can be provided as follows.

A magnetic switch comprises a detector in the center of a sensing area. The perimeter of the area represents the switching threshold distance. The switch is programmed so this distance to the perimeter is linked to a value of the magnetic field, being the magnetic threshold, or simply 'threshold' as mentioned earlier. A magnetic field lower than the threshold will not trigger switching. The detector is configured in accordance with the field of the source, so the distance of detection can be set by setting a threshold, since the magnetic field has a well-known dependency with distance. For example, if the object is a magnetic source with a fixed magnetic field (e.g. a permanent magnet), a detected field smaller than the threshold translates to the object being outside the area. The object outside the area does not trigger the switching. However, while the object approaches the detector, the detected magnetic field increases, and once the object enters the area, there is a response triggered in the switch. The accuracy of the switch depends on the accuracy of the magnetic field as a representation of the distance to the source. The method of performing the measurement of the field plays an important role in the accuracy.

Existing methods entail measuring the magnetic field and comparing it with the threshold, to check if the object is close enough to trigger a response of the switch.

However, measuring the magnetic field of the object is usually done by obtaining signals depending on each of the magnetic field components, e.g. Bx, By, Bz in a 3D case. The signals need to be processed to obtain whether the object is close enough or not. Alternatively, the signals need to be compared in a look-up table (LUT). This requires a look-up table with a large amount of data, or a drastic simplification of the model.

Where reference is made to a 'measurement signal' of a field component, or a 'measurement' for short, reference is made to the signal provided by the sensing system representative of the value of the magnetic field for that component. In some embodiments, the measurement signal represents the magnitude and the direction (e.g. the polarity, as positive and negative), however in some embodiments it may represent only the magnitude or absolute value, without information on polarity.

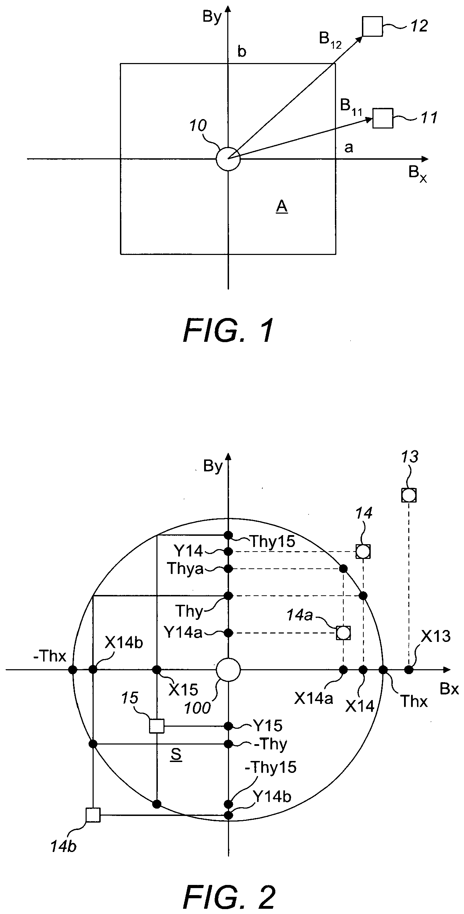

FIG. 1 shows a region A, defined by magnetic field magnitude thresholds a and b in the directions of Bx and By respectively, wherein the point 10 represents zero value of the magnetic field. This is a simplified model, where each measured magnetic field component of an object 11, 12 is compared to the predetermined thresholds a, b. The magnetic field of the objects 11 and 12 is represented by the vectors B₁₁ and B₁₂ in the magnetic field plane, which vectors have two components, one in the direction of Bx and the other in the direction of By, which are then compared to the thresholds a and b, respectively. It is apparent that such simplified model may lead to switching at different field strengths. A magnetic field with small By component will switch when its strength is close to the threshold a in the other, Bx, direction. But if the field has a large component in both directions, the switching will occur at a higher total magnetic strength. This has an effect where the triggering of signal in a proximity detector depends on the relative position and approaching direction of the detector relative to the moving object. Hence, comparing each component of the field with a fixed value of the threshold is not an accurate approximation for a proximity detector.

It is possible to calculate the vector magnitude of the field based on the value of the detected field components, e.g. Bx and By, and compare it with a preferably circular sensing threshold. In order to obtain the most accurate results, the vectorial magnitude can be calculated from the square sum of said components, (Bx)²+(By)² being representative of the projection in the plane of the magnetic field. Comparing that sum to a threshold value, being the radius of the circular sensing threshold, is equivalent to checking whether the vector Bx, By is inside or outside the circle. However, several calculations need to be performed to obtain the vectorial magnitude, which requires high processing power. Besides processing power, processing speed is an important factor. Since the measurements are performed continuously and the speed of the source relative to the detector is an important factor, the calculations need to be done very fast in order to have real time measurements and reasonably fast switching. Fast processing is also an important requirement.

Thus, computing the magnitude of the vector requires complex calculations, which leads to high processing power and high-speed requirements. On the other hand, a simple comparison of each measured component of the field with a threshold provides an estimation which is not viable, or it is less desirable and less accurate in many applications. The present invention provides a result with slightly reduced resolution for switching, but effective for most sensing applications, e.g. automotive applications in where the speed is also important, also for detecting tampering of other measurement devices such as electrometers, etc.

The present invention provides a sequential procedure to determine whether the object is within sensing threshold or not. First, a field component is measured, and compared with a predetermined threshold for that component. FIG. 2 shows a circular sensing threshold S of a 2D switch in the plane of view. This is just an example, and different applications may require other shapes. FIG. 2 shows the case where a magnetic field generated by an object at a given distance, the field being represented by the indicated point 13, has a component X13 which can be measured. The value of the magnetic field component is larger than the maximum threshold Thx for that component. The status of the switch is completely determined, without further signal processing or signal acquisition. This may indicate that the source of the field is close enough, within a predetermined distance chosen in accordance with the application and taking into account the flux or magnetic strength of the moving magnet. On the other hand, the value of the component may be lower than the threshold Thx. Instead of triggering signal, in embodiments of the present invention, this actually triggers a further comparison.

In general, the measured component is compared with the threshold that could trigger detection. The predetermined threshold value Thx in FIG. 2 is the magnetic threshold for that component (which in some embodiments has the same absolute value as in the perpendicular direction Y because it is usually desired that the measurement is not affected by the direction of approach). If the magnetic field threshold Thx is surpassed, the object is unambiguously inside the threshold of detection, so the status of the switch can be considered completely determined. In some embodiments, the status can be stored for later use, and further operations of measuring and comparing may continue as explained below. In some embodiments, however, the switch may be adapted to provide the output, since further operations are not required. This significantly reduces complexity of operation and processing time. In some embodiments, the signal obtained from the measurement can represent the absolute value of the component, so the absolute value of the component is compared to the threshold, which may be a positive value also.

The measured component may be lower than the predetermined threshold, here Thx. In this case, it is necessary to check other components, e.g. since the position of the target may still be outside the sensitivity perimeter. Another threshold in a different direction is also determined. The way of determining the additional or second threshold will be explained further below.

Once the additional or second threshold Thy is determined, the second measured component Y of the field is compared with this threshold.

If the second measured component does not surpass the second threshold, the magnetic field component is too low to trigger switching, which can be interpreted as a magnetic object being too far removed from the detector. If it is high enough, the magnetic field (e.g. its absolute value) can be considered as surpassing the sensing threshold, and the detector provides the predetermined signal (e.g. a proximity signal). In some embodiments, the switch may be configured to provide the value of the output at this point, e.g. the status of no detection within the range, or the status of detection if the field surpasses the threshold. In case of a 2D switch, no more comparisons may be done.

The threshold can be defined in different ways, resulting in different shapes for the area. For example, FIG. 2 shows a circle S results in a direct relationship between the threshold for perpendicular magnetic field components X, Y, given by the equation of the circle. Other shapes could be applied, however. Additionally, the direction of the field components may be other than X, Y as long as they are different from each other. In some embodiments, the different directions are orthogonal to each other.

In the case of FIG. 2, the value of the magnetic field is represented by the position 14 which can be represented by its components, with a particular value for the component in X direction X14 under the threshold Thx, which could mean that the field is too low to trigger detection. However, the field 14 may still be higher than the threshold for the signal, despite that for one component it is too low. Each position along the horizontal axis X determines at least one point (in a perpendicular axis Y) determining a threshold Thy in that direction, which corresponds to the second threshold value Thy. The values of the threshold may correspond to respective values X for the perpendicular component, depending on the shape of the area S In this case, the relationship between the thresholds for these different components is given by the equation of the circle. In other words, the value of the component X of the magnetic field in that direction determines the threshold for the magnetic field of a different component Y (thus in a different direction). For a component X14 of the field 14 in FIG. 2, at least one threshold Thy can be defined. If the component Y14 of the field 14 in the different Y direction is higher than Thy, the magnetic field is high enough so that the detection is triggered. Otherwise, if the component in that direction does not surpass the second threshold, the field is too low and this may mean the source is too far away from the detector to provide triggering of signal. For example, the object may provide a magnetic field 14a with component X14a in one direction for which a predetermined threshold Thx is defined. The component X14 is lower than this threshold. Then the value of the component X14a is used to calculate a second threshold Thya. A second measurement in the perpendicular direction provides a value Y14a, which results also a lower value than the second threshold Thya. Since the field is too low, the switch does not detect proximity.

This case is valid as long as the measured magnetic field components are positive, or if the measurement signals correspond to the magnitude (absolute value) of the respective component of the field.

If the measurement signal includes information of the direction of the component (meaning the polarity, positive or negative, e.g. north or south, of the component of the measured field), then it is possible to obtain more information regarding the field. This can be applied to unipolar (south/north) switches and latches, which do not use absolute values. However, the measurement signal needs to be compared with the appropriate threshold, taking into account the polarity, in order to unambiguously determine whether or not the component surpasses the threshold.

Considering a field 14b with at least one negative component (in this case both components X14b, Y14b are negative), in a first step, the first measurement signal is compared to the first threshold. If the polarity of the component is positive, it is compared to +Thx, however if the polarity of the component is negative, the measurement signal X14b should be compared to -Thx. If the measurement signal is lower than -Tx, then the threshold is surpassed (in negative value). Otherwise the switching continues the procedure. This can be applied easily as an algorithm, for example dropping the signs during the calculation of the results of the comparison. Alternatively, the measurement signal can be compared to both +Thx, -Thx, and if the result of both comparisons gives the same result, the component of that field unambiguously surpasses the threshold. However, if the comparison gives different results, then the signal for that component is between +Thx and -Thx, meaning within the circumference, so the switching status is still not completely determined.

The measurement signal is then used for obtaining a new threshold, for example in both polarities (Thy, -Thy), in a different direction as explained below. A new measurement is performed, and a measurement signal Y14b including the polarity information is obtained. The measurement signal is compared with the threshold Thy in each polarity. If the measurement signal is lower, respectively higher, than the threshold in both polarities (if By=Y14b<Thy, and By=Y14b<- Thy, which is the case depicted in FIG 2, respectively if By>Thy, By>-Thy), then the field is higher than the threshold. This means that the point representing the field is outside the circumference defined by the threshold, so the output is known and e.g. the switch detects proximity, since the value of field is higher than the predetermined value. If however the comparison has different results, then the measurement signal is lower than the threshold. Such exemplary magnetic field is represented in FIG 2 with the point 15 within the third quadrant of the threshold circumference. More in detail, if the measurement signal of the component in that direction is higher than the corresponding threshold in one polarity and lower than the threshold in the other polarity (e.g. if By=Y15<Thy15 and Y15>-Thy15, depicted in FIG 2 for the third quadrant magnetic field 15), then the signal is lower than the threshold (meaning that the point representing the field is within the circumference), so the magnetic field is considered to be lower than the threshold (which would mean, for example, that the field is outside the sensing range, and the output signal of the switch has a defined value, e.g. 0).

It is noted that, in the usual case in which the switching threshold follows a symmetrical shape such as a circumference, the threshold in both polarities can be obtained from the previous measurement, irrespectively of the polarity of said measurement signal. In other words, a measurement signal for a positive first component +X of the field results in two given threshold values +Thy, -Thy, and a measurement signal for a negative first component -X of the field results in the same two given threshold values + Thy, -Thy.

In some embodiments, the second threshold can be determined by the computation of a function, a circle in this example, or using a LUT. In case the threshold is determined by computation, the input to the function is a value of the magnetic field in a first direction, or its absolute value, for example the measurement signal obtained in the previous step for the corresponding component of the field. Then, the threshold value of the field in a second direction can be obtained, e.g. by calculation. The switch may include computation means. Alternatively, in case the second threshold is determined with a LUT, the switch may store said LUT, which links a plurality of values for the previously obtained measurement signal of the field component X in a first direction (or its absolute values) with values of the threshold Thy in a different direction. In other words, the LUT may link several values of one component of the magnetic field with corresponding threshold values of a different component of the magnetic field. The obtained second threshold value of the component is then compared to the measured component.

In some embodiments, specifically in detectors, the magnetic field component in different directions can represent distances between the position of a moving magnetic source and a detector, and the threshold field represents a threshold area, e.g. a sensing area (which may be circular, avoiding different results depending on the direction of the movement), for a fixed value of the field. A moving magnetic source triggers a signal when entering the sensing area, if the source emits a field such that it equals the threshold field of the detector at the specified distance.

In summary, from the measured value of one component of the field in a first direction, a value in a different direction of the field is obtained, which serves as a second threshold to compare another measured component of the field in a second direction different from the first. In some embodiments the directions may be orthogonal.

The threshold values are obtained from a previously measured value, either by calculating it (based, for example, in the equation of the circumference, or the like), or by finding the value using a lookup table, including using interpolation or any other statistical method.

In some embodiments, the switch can be a 3D switch. Until now, the magnetic field components were measured in a plane defined by Bx and By. In the case of 3D switches, a sensing volume is defined rather than an area. FIG. 2 shows an example of a field 13, 14 wherein the detector detects two field components which are high enough to surpass the threshold. However, if the threshold is not surpassed, a new threshold based on the previous measurement is calculated for a different direction, and the measurement signal for a component in that direction is compared to the new threshold. This can extend to a further, different, direction.

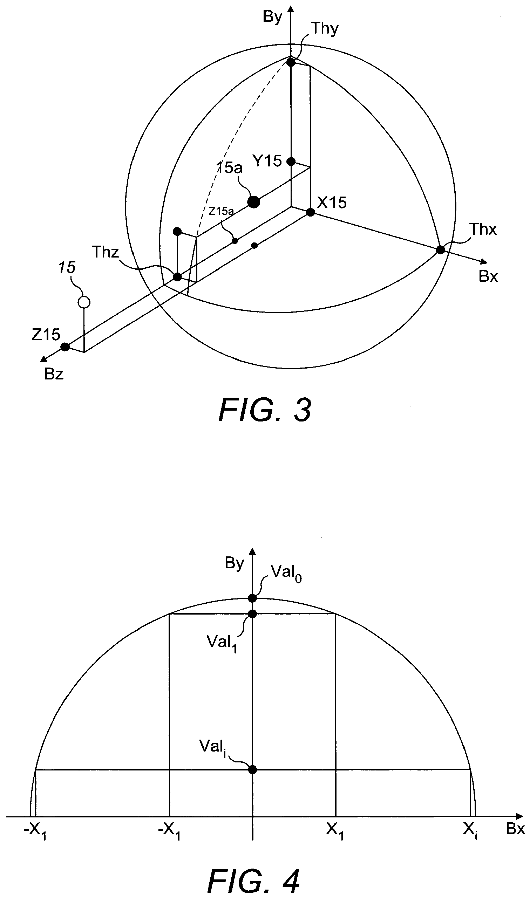

The field represented by the point 15a in FIG. 3 is lower than the field threshold of detection. The component X15 in the first direction X is lower than the first (predetermined) threshold Thx assigned to that direction. From the measurement of the magnetic field in the first direction X, the threshold Thy in the perpendicular second direction Y is obtained. The detector measures the component Y of the magnetic field in that same direction. The threshold Thy is compared to the measured component Y for the same direction. The threshold is also not surpassed. In some embodiments where only 2D are considered, in principle, the field is under the triggering threshold, so the object would be considered outside the area for which there is a trigger of signal.

In a 3D switch, a third threshold can be defined in a third direction different from the other two, e.g. orthogonal to the other two. The value of the component in this third direction of the magnetic field is obtained (optionally the absolute value of the component) and compared with the third threshold. This determines, finally, whether or not the field is high enough to trigger switching response. Such switches may be useful to provide accurate proximity sensors, capable of detecting spatially that an object is close enough to trigger switching response.

The threshold can be defined in different ways, resulting in different shapes for the volume as explained before. For example, a spherical volume is described as a direct relationship between the threshold in the third component of the field (in the corresponding third direction) and the threshold in the other two directions, given by the equation of the sphere. This is shown in FIG. 3 where a threshold Thz in a third direction is defined based on the measurements of the magnetic field in the previous directions. One of the previous measurements or both measurements could also be included in a LUT for determining the threshold value in the third direction. In the case of FIG. 3, a magnetic field 15 can be considered, wherein the first two components X15 and Y15 are the same as for the case of the magnetic field 15a discussed earlier. Based on the components X15 and/or Y15, and on the equation of the sphere, a threshold Thz can be provided. For the magnetic field 15a discussed earlier, the measurement of the component in the third direction Z15a results in a lower value than the threshold Thz in the third direction, so the detector would not trigger the signal. However, for the other magnetic field 15, the measurement of its third component Z15 results in a value which surpasses the threshold Thz, and there is triggering of the signal.

Other shapes could be considered for different shapes, which results in other ways of determining the thresholds. For example, if it is cylindrical, the threshold in a third direction may also be predetermined while the threshold in the second direction and the first direction may be related through the equation of the circumference. The relationship can be provided by calculation, or alternatively a look-up table can be envisaged where two inputs lead to different thresholds in the third direction.

It is noted that the measurement signal may represent the absolute value of the respective component, or may include information related to the polarity. In such cases, the discussion of the polarity relative to the positive and negative thresholds, made with reference to FIG. 2, can extend to the third dimension in the case of 3D switches.

In some embodiments, the switch can be configured to perform a comparison one axis at a time. If the first predetermined threshold is not exceeded, then the new threshold for the next axis is selected based on the previous value of the field. For example, a first threshold Thx corresponding to the radius of sphere is applied to the first sensing direction, e.g. X. If the threshold is not exceeded, then a second threshold Thy as a function of the previously measured field is applied to the second sensing direction (e.g. Y). The process is repeated for the 3rd direction (e.g. based on one or both directions). The switch can be configured to provide any result of a comparison at any point of the sequence which surpasses or exceeds the threshold at the given point of the sequence, or the result of the last comparison, as the output signal representative of the switch status. This is provided through a connection, for further processing, to a signalization means such as a display, etc.

Alternatively, one or more measurement of each component can be done, and respective comparisons can be made, and based on the results of each comparison, the output can be determined. In case a comparison results in surpassing the threshold, if the switch is configured to perform a further measurement and comparison, the new threshold is taken as the highest threshold for that direction, e.g. the crossing of the circumference with the Y axis or Z axis. Additionally, several measurements of the component may be done for statistical error determination, e.g. before comparing the average value to the corresponding threshold. The output may also be provided after several sequential measurements and comparisons. Other ways of data treatment known in the art can be applied.

In summary, the switch includes a sensing part which measures magnetic field components in different directions. The switch also includes a comparing part which sequentially compares the measured components with a threshold corresponding to the direction of the component. Since at least a further comparison requires obtaining the threshold value from a previous measurement signal, the switch performs at least one determination of a threshold sequentially after a previous measurement. The first threshold is predetermined. The first threshold can be chosen based on the application, based e.g. on the magnetic field strength of the used magnet, the desired switching distance, etc. The switch has a defined initial state. If the magnetic field crosses the threshold, the switch toggles to the other possible value, 1 or 0. For example, the first measured component may surpass the first threshold, (so, if abs(Bx)>Thx, switch provides output 1). If the first measured component does not surpass the first threshold, a second threshold in a second direction is obtained. The switch status is determined if the second measured component, in a direction different from the first, exceeds the second threshold. If it does not, a third threshold is used (for 3D switches) and the switch provides the output signal representative of the state of the switch, the state being dependent on whether the third measured component exceeds the third threshold or not.

At least one threshold for comparison with a further measurement is obtained from a previous measurement of the field in a previous direction. In 3D switches, the second and/or third thresholds for subsequent directions can be obtained from measurements made in previous iterations.

Obtaining these thresholds can be simplified in different ways. For example, two thresholds may be fixed, while a further threshold is obtained or extracted from the previous measurement(s). Where the shape of the sensing area or volume has symmetry, it is enough to calculate absolute values, or store absolute values. Additionally or alternatively, thanks to the symmetry, it is possible to take into account only one previous measurement for any or all further extractions of the further thresholds.

The switch could be adapted to perform measurement of every component, obtaining redundant data for improving switching reliability. Redundant data could be used to implement for example filtering, majority voting, etc.

The switch may include necessary circuitry to perform the required measurements and comparisons automatically, so the switch may be configured or programmed in accordance with the following methods.

The sensing system may be adapted to measure the component of the field, and to provide signals representative of the measurements, optionally signals representative of the absolute value of the measurement of the component. The sensing system may comprise Hall sensing elements which provide the magnetic field components and, optionally, means to provide the absolute value of the measurements. Where the measurements are analogue signals, the signals can be processed to digital signals using any known means, such as an Analog to Digital converter (ADC) or the like. The absolute value can be easily obtained by dropping the sign bit. The absolute value can be provided using a processor, etc.

The sensing sequence starts with the measurement of a first component Bx of the magnetic field. The rest of components By, Bz can be also measured at this stage, or could be measured at any point before the relevant comparison, for example after obtaining the output indicating that a comparison with a component in a different direction may be needed. The 3D switch can be programmed to perform, as an example:
1) Compare Bx, optionally Abs(Bx), with a set threshold value Thx
   a) If Bx, or Abs(Bx) > Thx then output 1 is provided: the measured values exceed the threshold.
   b) Otherwise, calculate the threshold value Thy = f(Bx), from table 1 or by calculation.
2) Compare By, optionally Abs(By) with the value Thy
   a) If B(y) or Abs(By) > Thy then output 1 is provided: the measured values exceed the threshold.
   b) Otherwise, calculate the threshold value Thz=f(Bx,By) from table 2 or by calculation.
3) Compare Bz or Abs(Bz) with Thz
   a) If Abs(Bz) > Thz then output 1 is provided: the measured values exceed the threshold.
   b) If Abs(Bz) < Thz then output 0 is provided: the measured values do not exceed the threshold.

The present invention is not limited to this sequence. The first measured component could be any of the Bx, By and Bz and the next measured component (or components in a 3D case) could be also any of the of the Bx, By and Bz. Also, as mentioned above, all three components may be measured.

The following tables provide the comparison of the measured field components with the threshold for the following component. These values are also shown in detail in FIG. 4 for a circular sensing area (wherein the X, X₁, Xᵢ in the figure represents the field component B in the x direction, marked as Bx, Bx1, Bxi, respectively, in the table).

As it is apparent from the figure, symmetry allows reduction of the lookup table since the same threshold Valᵢ corresponds to two different components with the same value but opposite directions, Bxi and -Bxi. This is explained further below.

**Table 1 with n rows**

| | |
|---|---|
| Bx | Thy |
| -Bx1 | Val1 |
| ··· | ··· |
| Bxi | Vali |

**Table 2 with n² rows**

| | | |
|---|---|---|
| Bx | By | Thz |
| -Bx1 | -By1 | Val1,1 |
| ··· | ··· | ··· |
| Bxi | Byi | Vali,i |

There is no need to compute squares, as in the prior art, since it is only needed to obtain a threshold value from a previous measurement, rather than computing the value of the magnetic field and compare it with the threshold (e.g. radius of the sensing circular area). For a switch comprising look-up tables (such as Table 1 and 2 above), the processing is fast since there are less elements in the LUT than in the prior art for the same resolution. It additionally requires less memory, since for a resolution of n, only nxn = n² rows are required, instead of nxnxn = n³ rows.

These tables are valid for any shape of the volume. In the particular case of a spherical sensing volume, since the values of Thy are the same as Thz for y=0, Table 1 is not needed. This is also true for any shell shape wherein the projections on the x-y and x-z plane are the same (since y=0 is the x-z plane).

As mentioned earlier, it is possible to optimise the sequence by looking up absolute values of Bx and By in the look-up tables, if the volume is symmetrical. This cuts down the number of elements needed in a LUT by half. This is also shown in FIG. 4 for Table 3.

**Table 3 with n rows**

| | |
|---|---|
| Bx | Thy |
| 0 | Val0 |
| ··· | ··· |
| Bxi | Vali |

**Table 4 with n² rows**

| | | |
|---|---|---|
| Bx | By | Thz |
| 0 | 0 | Val0,0 |
| ··· | ··· | ··· |
| Bxi | Byi | Vali,i |

Alternatively, the 3D switch is programmed to perform:
1) Compare Abs(Bx) with predetermined threshold Thx
   a) If Abs(Bx)> Thx then output 1 is provided: the measured values exceed the threshold.
   b) If Abs(Bx)<Thx, look up Thy from LUT or calculate Thy=f(Abs(Bx))
2) Compare Abs(By) with Thy
   a) If Abs(By)>Thy then output 1 is provided.
   b) If Abs(By)<Thy, the threshold is fixed value, Thz=Val₀ or f(0). In some embodiments, said predetermined value of Thz is set as its maximum value (corresponding to the value of the field where the axis crosses the sphere), the present invention not being limited thereto)
3) Compare Abs(Bz) with Thz
   a) If Abs(Bz)>Thz then output 1 is provided.
   b) Otherwise output 0 is provided: the field does not surpass the sensing threshold.

In this case, Thz is a constant value regardless of the values of Bx and By. The maximum value of Thz may be used, instead of a different threshold value per measurement signal, in order to cover all the potential measurement signals that could correspond to values over the threshold. As before, the components could be compared rather than their absolute value, including information of the polarity (the signs) and comparing them with the threshold as explained earlier. The volume would be a cylinder if the relationship between the other two components is that of a circumference (either as a function or as values stored in the LUT). In other words, for some embodiments of a 3D switch, the first threshold and another threshold are fixed at a predetermined value, and the remaining further threshold is based on at least one measurement previously performed.

Although a preferred embodiment is a sphere, a cylinder is a good approximation, and this implementation of the LUT requires very little memory (n instead of n³). As before, the comparison could be done with the components, not only with their absolute values.

A variation of this embodiment provides Thz equal to a function of the absolute value of any one of the previous measurement, f(Abs(Bx)) or f(Abs(By)). These correspond to provide a particular area (e.g. a circle) in the x-z plane or in the y-z plane respectively (e.g. stored as a LUT).

**Table 5 with n rows**

| | |
|---|---|
| Bx | Thy |
| 0 | Val0 |
| ··· | ··· |
| Bxi | Vali |

**Table 6 with n rows**

| | |
|---|---|
| Axis (Bx, By, or Bz) | Thx, Thy, or Thz |
| 0 | Val0 |
| ··· | ··· |
| Bxi, Byi or Bzi | Vali |

Alternatively, the switch may be programmed to execute the following algorithm:

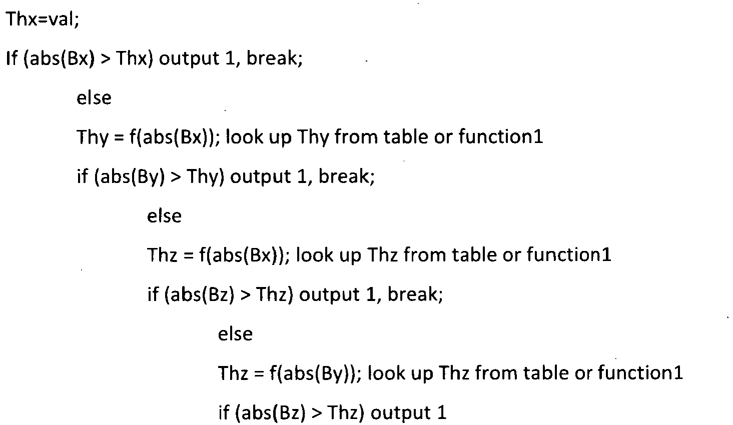

Thus, the two thresholds for one direction Z can be obtained, each from the measurement of the field component in each of the previous directions X, Y.

In the following, the magnetic sensing system is explained.

The magnetic sensing system of the switch may be any suitable sensing that can measure at least two magnetic components, producing signals that can be compared to a threshold value stored in the switch.

In general, a threshold for at least one magnetic component may take a value which depends on at least a previous measurement, e.g. via a table or a function calculation.

In some embodiments, the comparing means is configured to provide a third threshold based on the measurement of different components of the magnetic field. For example, the third threshold may be provided sequentially, based on the measurement of different components of the magnetic field.

The switch may be programmed to repeat multiple times the sequence of measurement and comparison of the values of the field components of the different axes (or directions). The output can be based on processing of these multiple measurements (e.g. for filtering purposes, to achieve more reliable switching). The provided subsequent threshold could be also based on multiple measurement of one and the same component of the magnetic field. The switch may be programmed to provide a subsequent threshold based on multiple measurement of a previous and same component of the magnetic field. Alternatively, a same subsequent threshold may be provided based on measurements of different components of the magnetic field. For example, the third threshold may be provided twice, each time based on a different component of the magnetic field (for ex. the first time based on Bx and the second time based on By). This can be used for allowing different sensing shapes (in area and/or volume), and possibly for detecting or reducing error.

In terms of filtering, there are several options, including:
- repeating measurement in one direction and its comparison (e.g. measure -compare (Bx, Thx), ..., measure-compare (Bx, Thx), meas.-comp. (By, Thy), ..., meas.-comp. (By, Thy), meas.-comp. (Bz, Thz), ..., meas&comp (Bz, Thz)), for example repeating each three times;
- performing a measurement of each component and its comparison in a sequence, and repeating the sequence few more times, e.g. twice more (e.g. meas.-comp. (Bx, Thx), meas.-comp. (By, Thy), meas.-comp. (Bz, Thz), meas.-comp (Bx, Thx), ..., meas.-comp (Bz, Thz)).

The switch may comprise a processing unit or controller or the like with the necessary elements such as comparators or the like and connections to receive the required measurement signals. These signals are obtained from the magnetic system of the switch.

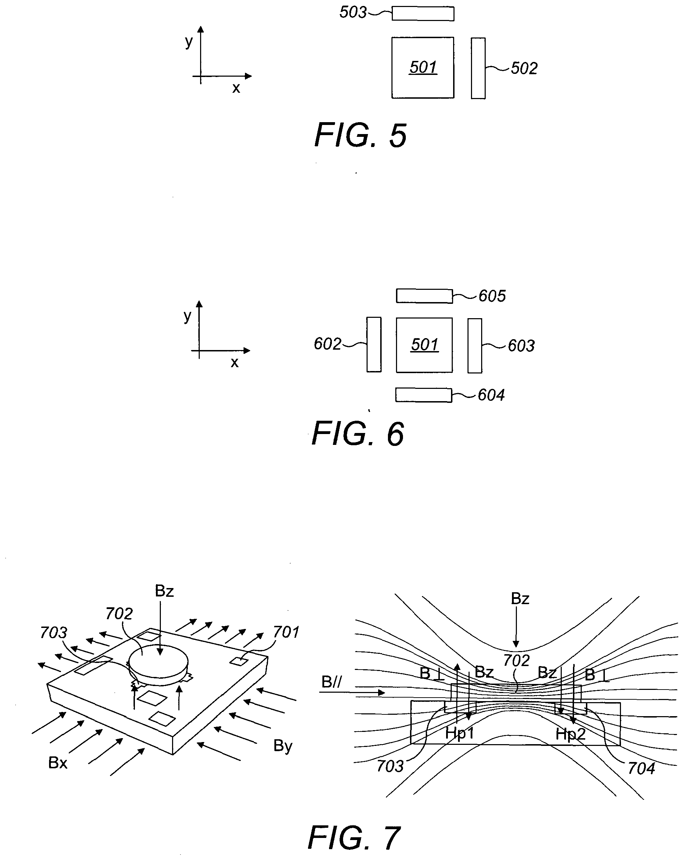

Focusing now on the magnetic sensing system itself, the system may comprise a magnetic sensor including sensing elements which are adapted to provide the required signals, e.g. two or three signals representative of the field components in two respectively three different directions. This can be provided in a single chip. Some examples of magnetic sensors are discussed with reference to FIG. 5 to FIG. 8, as follows.

In embodiments wherein the sensing elements are Hall elements, horizontal and vertical Hall plates may be provided in combination, optionally including one or more magnetic concentrators (e.g. integrated Magnetic Concentrator (IMC)). The Hall plates and optionally MCs may be combined to provide the required signals representative of the field components in the required directions, for example two or three different directions.

FIG. 5 shows a horizontal Hall plate 501 combined with two vertical Hall plates 502, 503 which can be used as part of the magnetic field sensing system in accordance with some embodiments of the present invention. They may be configured so that the signal provided by them represents the magnetic field components in 3 different directions, e.g. three perpendicular directions. For example, the vertical plates 502, 503 are sensitive to the field in X, Y directions and the horizontal plate 501 is sensitive to the vertical component Z of the field.

FIG. 6 shows an alternative embodiment wherein two vertical plates 602, 603 are sensitive to one horizontal component X and two other vertical plates 604, 605 are sensitive to a horizontal component Y in different direction, e.g. perpendicular, to the previous component X. These can be used to obtain different combinations of the signals from the field if required, for example to reduce external influences such as noise and the like.

In some embodiments of the present invention, magnetic concentrators MC can be used, e.g. an integrated MC, in combination with Hall plates. FIG. 7 shows a perspective view on the left, and a cross section on the right, of a sensing system with one or more Hall plates 701 distributed through the surface, to obtain differential fields for example. There is a central IMC 702 surrounded by two pairs of horizontal Hall plates 703, 704 on opposite sides of the IMC. The IMC provides field component conversion, so the horizontal component of the field (e.g. Bx) can be converted into a combination of a parallel component B// and perpendicular component B1. The perpendicular components are detectable by the horizontal Hall plates 703, 704. In particular, the perpendicular component on one side of the IMC 702 extends in a direction (upwards) which is detectable by the first horizontal Hall plate 703 and in an opposite perpendicular direction (downwards) when crossing the second horizontal Hall plate 704 of the pair, on the other side of the IMC 702. On the other hand, the contribution of the perpendicular component Z of the field has the same direction in both Hall plates of the pair. Thus, it is possible to obtain the horizontal and vertical components by signal processing (e.g. subtracting both signals allows calculating the horizontal component Bx from the upwards and downwards component B1, and adding both signals allows calculating the vertical component Bz).

Thus, it is shown that two sensing elements may provide two signals representative of the field in two directions, either by providing one signal per sensing element as in FIG. 5, a gradient or difference thereof (as in FIG. 6), or by an appropriate combination of the signals provided by each sensing element, as seen in FIG. 7.

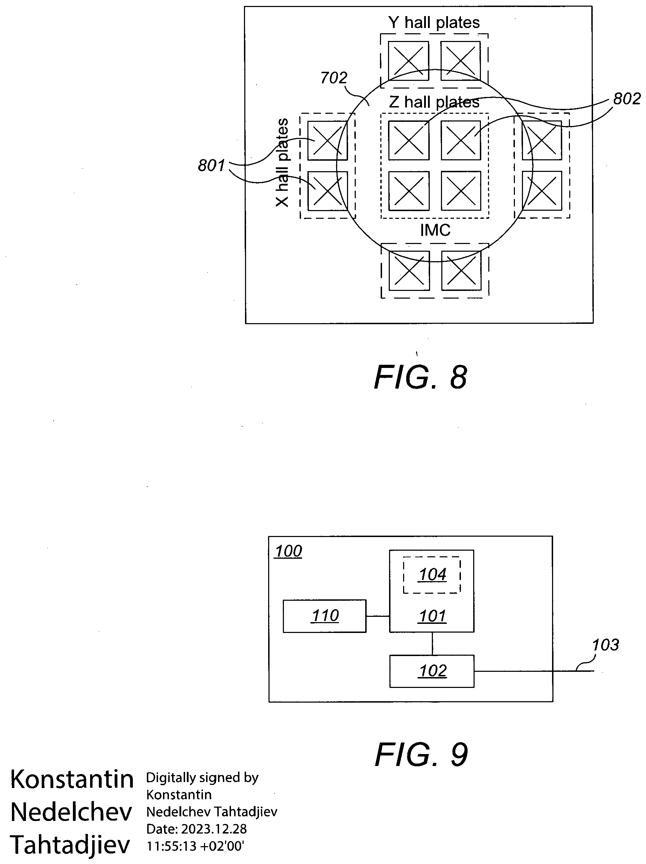

FIG. 8 shows, as a top view, an alternative embodiment of a sensing system, which is advantageously compact. The IMC 702 may be surrounded by horizontal Hall plates being the sensing elements 801 for obtaining the components of the field in two different directions X, Y. It may include additional horizontal Hall plates being additional sensing element 802 underneath the IMC, thus allowing saving space. These elements are sensitive to different components of the field, determined by the redirection of the field provided by the IMC. For example, two pairs of Hall plates may be provided on each side of the IMC, to obtain the components Bx, By, and further optional horizontal Hall plates 802 (e.g. four) can be placed underneath the IMC to obtain the vertical component Bz. These are optional since, in principle, the Bz component can be calculated from the signal of the different Bx or By plates, by signal processing.

FIG 9 shows a schematic of a switch in accordance with embodiments of the present invention, including a magnetic field sensing system 110 and a comparator. An electronic unit 101 receives a measurement signal from the sensing system 110 and it allows obtaining at least one further threshold from at least one previously performed measurement, e.g. by calculation, or by a LUT stored in an optional memory unit 104. The unit may be a processor or the like. The unit 101, e.g. its optional memory unit 104, may also store a predetermined threshold value, e.g. the first threshold to which the first measurement is compared to. A comparator or in general comparing means 102 is connected to the unit 101 from which the threshold is obtained, and to the sensing system 110 from which the corresponding measurement to be compared is obtained. The output of the comparator 103 provides the signal to the output connection 103. In some embodiments, the magnetic sensing system 110 may be implemented as an integral unit, e.g. monolithically implemented in a semiconductor die, comprising e.g. IMCs, sensing elements including e.g. Hall plates, electronic circuitry for powering the elements, signal routing systems, and the like. In some embodiments, the magnetic sensing system may also comprise units such as comparators for providing the absolute value, which may be used also for other applications (such as comparing with a switching threshold).

In some embodiments, the magnetic sensing system is configured to provide a first set of thresholds, e.g. operating threshold, and a second set of thresholds, e.g. release threshold. The operating and release threshold are used due to the known hysteresis phenomenon. The values of the threshold are obtained in either case, as before, based on a measurement. Any of them or both may be based on e.g. a respective equation or LUT, as mentioned earlier. For example, for the same value of a given component of the field, an operating threshold value can be obtained with an equation (e.g. a circumference of an 'operating' radius) or an 'operating threshold LUT', and a release threshold value can be obtained with another equation (e.g. another circumference of a 'release' radius) or a 'release threshold LUT'.

In another embodiment, a release threshold is provided, and the comparison is done only in the direction where the operating threshold has been exceeded.

Thus, a component is measured and a comparison is performed against e.g. a predetermined value, or a value obtained from an earlier measurement. If the measured value surpasses the operating threshold value, then the same component is compared for the release threshold value for the same direction, wherein the release threshold value is also a predetermined value or a value obtained from an earlier measurement. The difference between the operating and release thresholds, Bop-Brp, is a predetermined value. Alternatively, the release threshold Brp may be predetermined fraction of the operating threshold.

In an aspect, the present invention provides a position sensing system comprising a magnet and a magnetic switch in accordance with embodiments of the previous aspect. The magnetic switch may detect the proximity of a magnet if the detected field surpasses a predetermined field value, wherein the magnetic field generated by the magnet is known. The magnetic field generated by the magnet may be 0.5 mT to 100 mT. For example, the position sensing system may be proximity sensor which senses the presence or absence of the magnet within the detection range, as the detected field surpasses or not the threshold. If the value of the field generated by the magnet is known, the threshold of the switch can be adapted to provide a signal when the magnet approaches, thus when the detected field surpasses the threshold. It is an advantage that the direction of motion does not have influence on the detection, with simple operations and utilization of LUTs.

The magnet may be a dipole, a quadrupole, etc. The choice of the type of magnet for the activation of the switch is done taking into account the particular application of the switch, in particular thermal considerations, which may affect the magnet.

A position sensing system or proximity sensing system in accordance with embodiments of the present invention provides a switching signal when the detected field surpasses the sensing threshold. The detection is provided as a function of the distance, irrespective of the orientation of the magnet in the plane, if the system comprises a 2D magnetic switch, or in the space if the system comprises a 3D magnetic switch, in accordance with embodiments of the present invention. This is enabled by a dynamic selection of different thresholds to compare with a currently measured component, wherein these thresholds depend on the value of the previously measured components of the field.

In a further aspect, the present invention provides a sequential method to provide switching of the (electric) status or output of a switch. The switch of the previous aspect can be used to carry out the method, e.g. it may be programmed for executing the steps of the method.

The sequence comprises at least the following steps:
- Measuring a magnetic field component in a first direction.
- Comparing the measured magnetic field component with a first fixed threshold.
- If the threshold is not surpassed, providing a further threshold in a further direction based on the previously measured magnetic field component
- Measuring a magnetic field component in the same further direction, and repeating the comparison with the further threshold.
- If at any point the measurement of a component surpasses the respective threshold, or all the components have been measured, output the result of the latest comparison.

As already explained, the threshold can be provided with an input of a previous measurement or absolute value thereof, using a function (e.g. a processor-implemented function) or a LUT. The comparison may be done using the absolute value of the magnetic field component. Analogously the threshold for the following measurement can be obtained from the previous measurement or its absolute value.

In a 3D switch, the threshold can be provided with an input of two previous measurements, or with any one of the previous measurements. The first and any one of the further thresholds may have a fixed value, as long as at least one threshold is obtained from a previous measurement or measurements.

The method may comprise the steps described with reference to any of the previous algorithms, depending on the required needs. Obtaining a threshold from a previous component may be done using the immediately previous measurement or from an earlier component or components. For example, if Bx is the first measurement, obtaining the second and/or third thresholds Thy, Thz can be done using the first measurement Bx. Obtaining the third threshold can optionally be done using the two previous measurements as input (for the function or the LUT). Any of these methods can be used in accordance with the particular shape of sensing area desired for the switch of the present invention.

In some embodiments, the method may comprise providing the third threshold based on the measurement of different components of the magnetic field. For example, the value of one of the previous measurements, or of both, can be taken into account. in some embodiments, the third threshold may be provided sequentially based on the measurement of different components of the field.

In some embodiments, the method comprises repeating each measurement and comparison multiple times. In some embodiments, the whole sequence of measurement and comparison of the different axes/directions can be repeated multiple times. The output can be done based on processing of these multiple measurements. This provides a reliable switching method.

The method may comprise providing a subsequent threshold based on multiple measurement of one and the same component of the magnetic field. Alternatively, a subsequent threshold may be provided based on measurements of different components of the magnetic field. The method may comprise also providing a subsequent threshold being a predetermined threshold (so the first threshold and another threshold are predetermined, as long as there is defined yet a further threshold based on a measurement previously performed.

## Claims

1. A magnetic switch (100) comprising a magnetic field sensing system (110) configured for performing a measurement of a first component of the magnetic field in a first direction and a measurement of at least a second component of the magnetic field in a second direction different from the first direction, and providing a measurement signal representative of each measurement,
further comprising comparing means (102) adapted for comparing the measurement signal with a respective threshold value,
the comparing means being adapted to provide a first threshold value for a first comparison with the first component in the first direction, the first threshold value being a predetermined value,
wherein the switch is configured to perform a further comparison using the measurement signal of a field component in a different direction and a subsequent threshold value,
the comparing means being further adapted to provide the subsequent threshold value for the further comparison,
wherein at least one of said subsequent threshold value is chosen in accordance with a measurement signal of at least one component of the magnetic field used in a previous comparison,
the magnetic switch (100) comprising a connection (103) to provide a signal representative of the result of at least one comparison as output signal.

2. The switch of the previous claim further comprising signal processing means (113) for providing a measurement signal of the measurement of a first component and/or of at least a second component, wherein the measurement signal is representative of the absolute value of the respective component of the magnetic field in at least one direction.

3. The switch of any one of the previous claims wherein the magnetic field sensing system comprises a sensing element being a Hall element (111) configured so that the direction of maximum sensitivity is the direction of the component being measured.

4. The switch of the previous claim further comprising one or more integrated magnetic concentrators for redirecting the magnetic field in at least one predetermined direction being the direction of maximum sensitivity of the Hall element.

5. The switch of any one of the previous claims wherein the comparing means comprises a look-up table with a list of threshold values corresponding to different measurement signals of at least one component of the magnetic field.

6. The switch of claim 5 wherein the look-up table comprises a list of threshold values corresponding to different measurement signals corresponding to absolute values of a component of the magnetic field.

7. The switch of any one of the previous claims wherein the switch is configured to repeat the comparison for a different component if the measurement signal of a component is lower than the corresponding threshold to which the measurement signal is compared to, until the measurement signals of each component has been compared, or until the measurement signal of at least one component is higher than the respective threshold.

8. The switch of any one of the previous claims,
wherein the comparing means are adapted to provide a subsequent threshold value for each subsequent comparison, wherein at least one of said subsequent threshold value is chosen in accordance with the measurement signal corresponding to the absolute value of at least one component of the magnetic field used in a previous comparison.

9. The switch of any one of the previous claims wherein the magnetic field sensing system is configured for providing a measurement signal of each component of the magnetic field in three different directions.

10. The switch of claim 9 wherein the comparing means is further adapted to provide a further threshold value being a predetermined value.

11. The switch of claim 9 wherein the comparing means is configured to provide a second and third thresholds based on the measurement signal of the same component of the magnetic field.

12. The switch of claim 9 wherein the comparing means is configured to provide a second and/or third thresholds based on the measurement signals of different components of the magnetic field.

13. The switch of any one of the previous claims being configured to provide an output signal being either the first output corresponding to a measurement of a component being higher that the respective threshold value, or the result of the last comparison, wherein the switch is adapted to stop the comparison sequence when the signal representative of the result of at least one comparison is provided.

14. A proximity sensing system comprising a magnet and a magnetic switch of any one of the previous claims for detecting the proximity of the magnet within a predetermined distance range, wherein the system is adapted to use the signal representative of the measurement to indicate proximity if a measurement signal surpasses its respective threshold.
